# EUROPEAN PATENT APPLICATION

(11) **EP 4 477 356 A1**
(43) Date of publication of application: **18.12.2024**
(21) Application number: 23752708.0
(22) Date of filing: 27.01.2023
(51) Int. Cl.: B24B 21/00, B24B 21/06

(54) **POLISHING HEAD AND POLISHING DEVICE**

(30) Priority: 09.02.2022 JP 2022018430
(71) Applicant: EBARA CORPORATION, Ota-ku, Tokyo 144-8510 (JP)
(72) Inventor: KASHIWAGI, Makoto, Tokyo 144-8510 (JP); FUJISAWA, Mao, Tokyo 144-8510 (JP)
(74) Representative: Pritzlaff, Stefanie Lydia
(86) International application number: PCT/JP2023/002698
(87) International publication number: WO 2023/153243

(57) **Abstract**

The present invention relates to a polishing head for pressing a polishing tape against a substrate, such as a wafer. The present invention further relates to a polishing apparatus for polishing a substrate with such a polishing head. The polishing head (10) includes a pressing mechanism (12) configured to press a polishing tape (2) against a substrate W, and a tape hook (40) configured to restrict movement of an edge of the polishing tape (2) in a direction toward the substrate (W). The tape hook (40) has a tape positioning surface (47) that faces a polishing surface of the edge of the polishing tape (2).

## Description

### Technical Field

The present invention relates to a polishing head for pressing a polishing tape against a substrate, such as a wafer. The present invention further relates to a polishing apparatus for polishing a substrate with such a polishing head.

### Background Art

In recent years, devices, such as memory circuits, logic circuits, and image sensors (e.g., CMOS sensors) have been becoming more highly integrated. In a process of manufacturing these devices, foreign matter, such as fine particles and dust, may adhere to the devices. The foreign matter adhered to the devices may cause short circuits of interconnects and may cause circuit malfunctions. Therefore, in order to improve reliability of the devices, it is necessary to clean a wafer on which the devices are formed and remove the foreign matter from the wafer.

Foreign matter, such as fine particles and dust as mentioned above, may adhere to a back surface (non-device surface) of a wafer. If such foreign matter adheres to the back surface of the wafer, the wafer may be separated away from a stage reference surface of an exposure device, causing a front surface of the wafer to tilt relative to the stage reference surface. As a result, patterning and focal length may be shifted. To prevent such problems, it is necessary to remove the foreign matter from the back surface of the wafer.

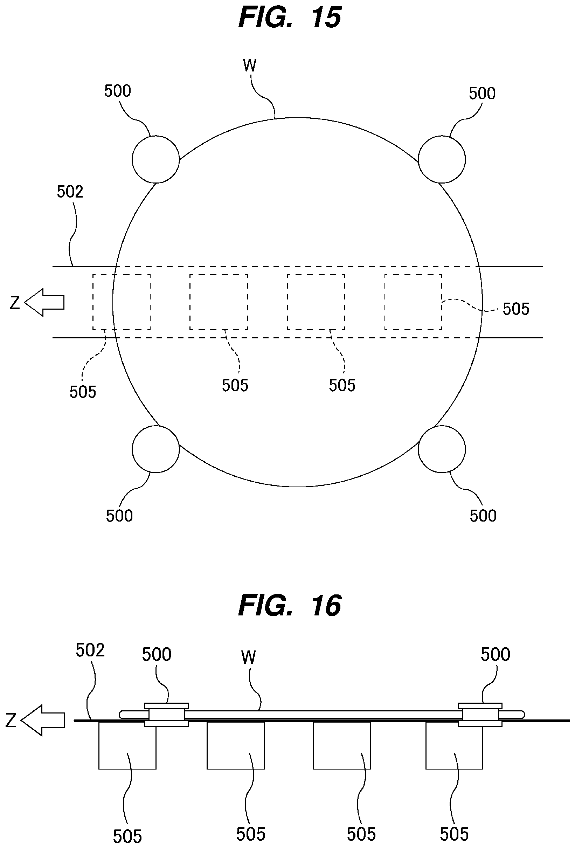

Therefore, as shown in FIGS. 15 and 16, a polishing apparatus is used to polish a back surface of a wafer with a polishing tape. FIG. 15 is a top view of a conventional polishing apparatus, and FIG. 16 is a side view of the conventional polishing apparatus shown in FIG. 15. In this polishing apparatus, a plurality of rollers 500 hold a periphery of a wafer W, and the rollers 500 themselves rotate to thereby rotate the wafer W. A polishing tape 502 is disposed on the back surface of the wafer W. A predetermined tension is applied to the polishing tape 502, while the polishing tape 502 advances in a direction indicated by arrow Z.

Multiple polishing heads 505 are arranged in a diameter direction of the wafer W. These polishing heads 505 are configured to press the polishing tape 502 against the back surface of the wafer W, thereby polishing the back surface of the wafer W. The polishing tape 502 pressed against the back surface of the wafer W can remove foreign matter from the back surface of the wafer W.

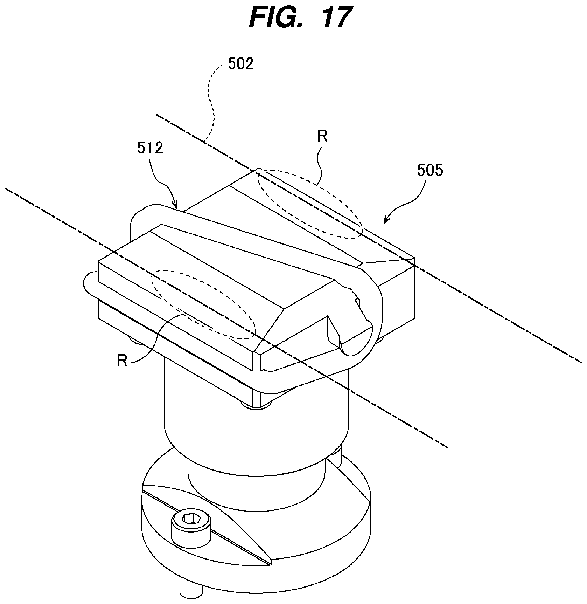

FIG. 17 is a perspective view of the polishing head 505. As shown in FIG. 17, the polishing head 505 has a pressing member 512 that presses the polishing tape 502 against the back surface of the wafer W. This pressing member 512 contacts the center of the polishing tape 502 in a width direction of the polishing tape 502 and pushes the polishing tape 502 toward the wafer W. The polishing tape 502 can polish the wafer W by receiving the pressing force from the pressing member 512.

### Citation List

### Patent Literature

Patent document 1: Japanese laid-open patent publication No. 2021-122895

### Summary of Invention

### Technical Problem

However, the polishing tape 502 is flexible but not stretchable. Therefore, edges of the polishing tape 502 that are not pressed by the pressing member 512 also follow the center of the polishing tape 502 and are elevated. As a result, the polishing tape 502 accidentally comes into contact with the wafer W. The edges of the polishing tape 502 indicated by symbols R in FIG. 17 are regions where the polishing tape 502 is not pressed by the pressing member 512, but contacts the wafer W and polishes the wafer W slightly. Since a polishing load cannot be controlled on the edge of the polishing tape 502 that is not pressed by the pressing member 512, a polishing rate of a portion of the wafer W polished by the edge of the polishing tape 502 becomes unstable. As a result, the polishing head 505 may not be able to uniformly polish a target area of the wafer W.

Accordingly, the present invention provides a polishing head that can prevent an edge of a polishing tape from unintentionally contacting a substrate, such as a wafer, and can control a polishing rate of the substrate. Further, the present invention provides a polishing apparatus having such a polishing head.

### Solution to Problem

In an embodiment, there is provided a polishing head for polishing a substrate, comprising: a pressing mechanism configured to press a polishing tape against the substrate; and a tape hook configured to restrict movement of an edge of the polishing tape in a direction toward the substrate, the tape hook having a tape positioning surface that faces a polishing surface of the edge of the polishing tape.

In an embodiment, the tape hook is disposed adjacent to the pressing mechanism.

In an embodiment, the tape hook comprises a plurality of tape hooks arranged at both sides of the pressing mechanism.

In an embodiment, the plurality of tape hooks have a plurality of tape positioning surfaces that face polishing surfaces of both edges of the polishing tape.

In an embodiment, the pressing mechanism comprises a pressing member configured to press the polishing tape against the substrate, the polishing head further comprises a pressing-member holder that holds the pressing member, and a distance from a reference plane in the pressing-member holder to an end surface of the tape hook is shorter than a distance from the reference plane to a tape pressing surface of the pressing member.

In an embodiment, the tape hook has a protrusion that protrudes toward the pressing member, one side of the protrusion forming the tape positioning surface and an opposite side of the protrusion forming the end surface of the tape hook.

In an embodiment, the protrusion is located between the substrate and the edge of the polishing tape.

In an embodiment, the tape hook and the pressing mechanism are movable together.

In an embodiment, there is provided a polishing apparatus comprising: a substrate holder configured to hold a substrate; and the polishing head configured to polish the substrate.

### Advantageous Effects of Invention

The tape hook can prevent the edge of the polishing tape from contacting the substrate. Therefore, unintentional polishing of the substrate by the edge of the polishing tape can be prevented.

### Brief Description of Drawings

[FIG. 1] FIG. 1 is a perspective view showing an embodiment of a polishing head for polishing a wafer by pressing a polishing tape, which is an example of a polishing tool, against a surface of the wafer which is an example of a substrate;
[FIG. 2] FIG. 2 is a cross-sectional view of the polishing head shown in FIG. 1;
[FIG. 3] FIG. 3 is a side view showing an embodiment of a tape hook;
[FIG. 4] FIG. 4 is a cross-sectional view showing a polishing tape supported by a pressing member and tape hooks;
[FIG. 5] FIG. 5 is a side view showing an embodiment of an arrangement of the tape hooks;
[FIG. 6] FIG. 6 is a side view showing another embodiment of the arrangement of the tape hooks;
[FIG. 7] FIG. 7 is a perspective view showing another embodiment of the polishing head; [FIG. 8] FIG. 8 is a side view showing an embodiment of an arrangement of the tape hooks;
[FIG. 9] FIG. 9 is a side view showing another embodiment of the arrangement of the tape hooks;
[FIG. 10] FIG. 10 is a side view showing still another embodiment of the arrangement of the tape hooks;
[FIG. 11] FIG. 11 is a side view showing an embodiment of a polishing apparatus;
[FIG. 12] FIG. 12 is a top view of the polishing apparatus shown in FIG. 11;
[FIG. 13] FIG. 13 is a perspective view showing an embodiment of a polishing head including a fluid pressing structure;
[FIG. 14] FIG. 14 is a perspective view showing another embodiment of a polishing head including a fluid pressing structure;
[FIG. 15] FIG. 15 is a top view of a conventional polishing apparatus;
[FIG. 16] FIG. 16 is a side view of the conventional polishing apparatus shown in FIG. 15; and
[FIG. 17] FIG. 17 is a perspective view of a conventional polishing head.

### Description of Embodiments

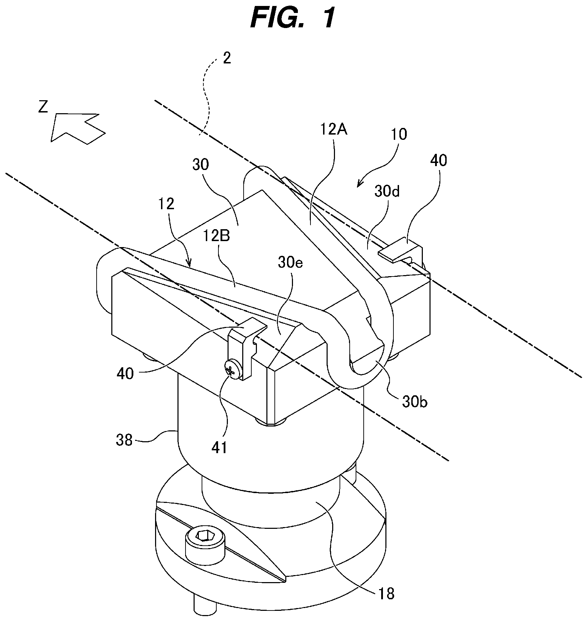

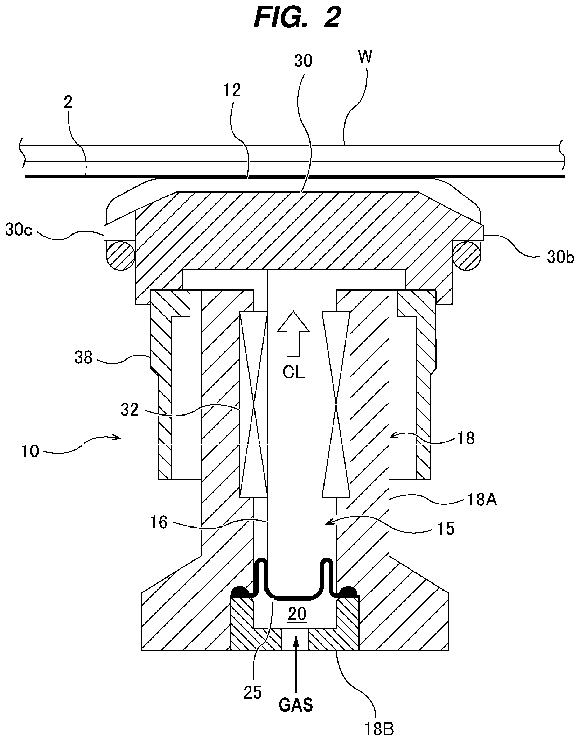

Hereinafter, embodiments of the present invention will be described with reference to the drawings. FIG. 1 is a perspective view showing an embodiment of a polishing head 10 for pressing a polishing tape 2, which is an example of a polishing tool, against a surface of a wafer W, which is an example of a substrate, to polish the wafer W. FIG. 2 is a cross-sectional view of the polishing head 10 shown in FIG. 1. The polishing head 10 of this embodiment is disposed under the wafer W and the polishing tape 2, and is disposed so as to press the polishing tape 2 against a back surface of the wafer W from a back side of the polishing tape 2.

The polishing head 10 includes a pressing member 12 serving as a pressing mechanism configured to press the polishing tape 2 against the wafer W, an actuator 15 configured to move the pressing member 12 in a predetermined pressing direction indicated by an arrow CL to apply a pressing force to the pressing member 12, and a housing 18 in which the actuator 15 is disposed. The actuator 15 includes a movable shaft 16 coupled to the pressing member 12, and a partition membrane (diaphragm) 25 forming a pressure chamber 20 between an end of the movable shaft 16 and the housing 18. The movable shaft 16 and the partition membrane 25 are disposed in the housing 18.

The polishing head 10 further includes a pressing-member holder 30 configured to hold the pressing member 12. The pressing-member holder 30 is coupled to the movable shaft 16 and can move together with the movable shaft 16. The pressing member 12 has an annular shape as a whole, and the pressing member 12 is removably held by the pressing-member holder 30. The pressing-member holder 30 has a fitting groove (not shown) into which the pressing member 12 fits. The annular pressing member 12 is hung on the pressing-member holder 30, with the pressing member 12 elastically deformed while fitting into the fitting groove. The pressing member 12 of this embodiment has two tape-pressing surfaces 12A and 12B for pressing the polishing tape 2 against the wafer W.

The pressing member 12 is made of an elastic material. Examples of material constituting the pressing member 12 include rubber, such as fluororubber, silicone rubber, and ethylene propylene diene rubber. The pressing member 12 has a circular cross section. The pressing member 12 may be an O-ring. In this embodiment, the pressing-member holder 30 has protrusions 30b and 30c on its side surfaces. The protrusions 30b and 30c support the pressing member 12 in an elastically deformed state.

It is noted that the pressing member 12 is not limited to this embodiment, and may have other shape or may be made of other material. For example, the pressing member 12 may have only one tape-pressing surface for pressing the polishing tape 2 against the wafer W. In another example, the pressing member 12 may have a shape of a linearly extending blade or a curved blade instead of the annular shape.

As shown in FIG. 2, the movable shaft 16 is movable in its axial direction in the housing 18, and the movable shaft 16 can raise the pressing member 12 in the pressing direction indicated by the arrow CL. The pressing member 12 faces the back side of the polishing tape 2. When the movable shaft 16 raises the pressing member 12 in the pressing direction indicated by the arrow CL, the pressing member 12 comes into contact with the back side of the polishing tape 2. The pressing member 12 presses a polishing surface of the polishing tape 2 against the back surface of the wafer W to polish the back surface of the wafer W with the polishing tape 2. During polishing of the wafer W, the back side of the polishing tape 2 is supported by the pressing member 12. The back side of the polishing tape 2 is a surface opposite to the polishing surface having abrasive grains. During polishing of the wafer W, the polishing tape 2 is advanced in its longitudinal direction at a predetermined speed.

In this embodiment, the movable shaft 16 is configured as a ball spline shaft. A ball spline nut 32 is disposed in the housing 18, and the movable shaft 16 is supported by the ball spline nut 32 so as to be movable in the axial direction of the movable shaft 16. In one embodiment, the movable shaft 16 may be movably supported by an inner surface of the housing 18.

The housing 18 includes a housing body 18A having a space formed therein for accommodating the movable shaft 16, and a lid 18B for closing the space. The lid 18B is detachably fixed to the housing body 18A by a screw (not shown). The actuator 15 is configured to generate a pressing force for pressing the polishing tape 2 against the wafer W. The actuator 15 includes the movable shaft 16 and the partition membrane 25. The partition membrane 25 is in contact with an end (lower end) of the movable shaft 16. An edge of the partition membrane 25 is sandwiched between the housing body 18A and the lid 18B. The partition membrane 25 is only in contact with the movable shaft 16, but is not fixed to the movable shaft 16.

The partition membrane 25 is made of a flexible material. Examples of material that can be used to form the partition membrane 25 include chloroprene rubber, fluororubber, and silicone rubber. The pressure chamber 20 is coupled to a compressed-gas supply line (not shown), so that compressed gas (e.g., compressed air) is supplied from the compressed-gas supply line into the pressure chamber 20.

During polishing of the wafer W, the compressed gas, such as compressed air, is supplied into the pressure chamber 20. The pressure of the compressed gas in the pressure chamber 20 acts on the end (lower end) of the movable shaft 16 through the partition membrane 25, and elevates the movable shaft 16, the pressing-member holder 30, and the pressing member 12. The polishing head 10 may further include a distance sensor configured to measure a movement distance of the movable shaft 16 relative to the housing 18. When polishing of the wafer W is to be terminated, the pressure chamber 20 is opened to the atmosphere, and as a result, the movable shaft 16 and the pressing member 12 are lowered by the weight of the movable shaft 16 and the tension of the polishing tape 2.

A skirt 38 is fixed to the pressing-member holder 30. This skirt 38 extends downward from the pressing-member holder 30 and surrounds an upper part of the housing 18. In this embodiment, the skirt 38 has a cylindrical shape, but may have other shape as long as the skirt 38 can surround the upper part of the housing 18. The skirt 38 can prevent liquid, such as pure water used in polishing of the wafer W, from entering the housing 18.

As shown in FIG. 1, during polishing of the wafer W, the polishing tape 2 advances at a predetermined speed in a longitudinal direction of the polishing tape 2 as indicated by arrow Z. The pressing member 12 in this embodiment extends obliquely with respect to the longitudinal direction (advancing direction Z) of the polishing tape 2. When polishing the wafer W, the pressing member 12 presses the polishing tape 2 from its back side against the wafer W.

As shown in FIG. 1, the polishing head 10 includes a plurality of tape hooks 40. Each tape hook 40 is removably attached to the pressing-member holder 30 by a screw 41. The tape hooks 40 are configured to limit movement of edges of the polishing tape 2 in a direction toward the wafer W. More specifically, when the pressing member 12 presses the polishing tape 2 against the wafer W, the tape hooks 40 prevent the edges of the polishing tape 2 from contacting the wafer W. The pressing-member holder 30 has slope surfaces 30d and 30e that are inclined downward from the pressing member 12 toward the tape hooks 40.

The tape hooks 40 and the pressing member 12 can move together. Specifically, the tape hooks 40 and the pressing member 12 are moved together toward the wafer W by the actuator 15 shown in FIG. 2. The tape hooks 40 are disposed adjacent to the pressing member 12, but are not in contact with the pressing member 12. In this embodiment, the plurality of tape hooks 40 are disposed at both sides of the pressing member 12. Specifically, the plurality of tape hooks 40 are disposed at both sides of the polishing tape 2, and limit the movement of both edges of the polishing tape 2 in the direction toward the wafer W.

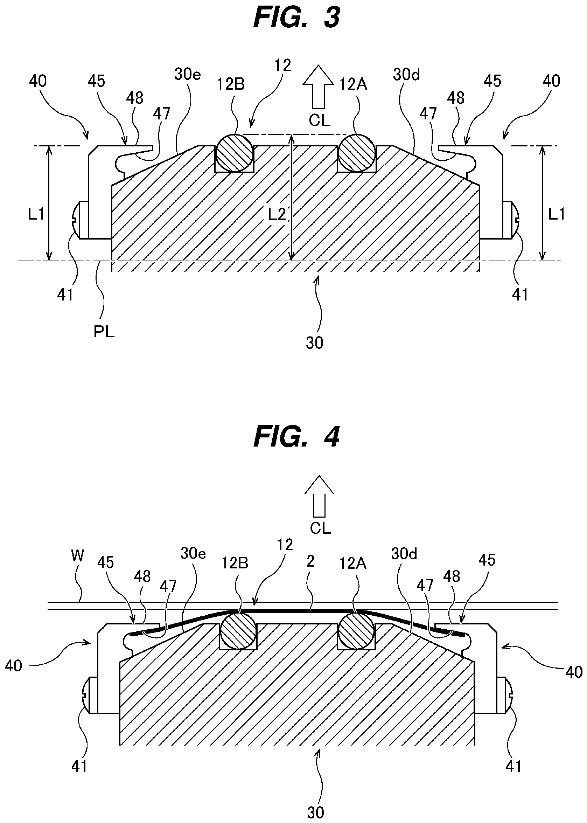

FIG. 3 is a side view showing one embodiment of the tape hooks 40. As shown in FIG. 3, each of the tape hooks 40 has a protrusion 45 protruding toward the pressing member 12. The protrusion 45 has a tape positioning surface 47 that faces the polishing surface of the edge of the polishing tape 2. One side of the protrusion 45 constitutes the tape positioning surface 47, and the other side of the protrusion 45 constitutes a flat end surface 48. In this embodiment, the protrusion 45 has a tapered shape. The tape positioning surface 47 is inclined upward toward the pressing member 12. The protrusion 45 is located between the wafer W and the edge of the polishing tape 2. Therefore, the edge of the polishing tape 2 does not contact the wafer W.

A distance L1 from a reference plane PL in the pressing-member holder 30 to each end surface 48 of the tape hook 40 is shorter than a distance L2 from the reference plane PL to the tape pressing surfaces 12A, 12B of the pressing member 12. The reference plane PL is an imaginary plane perpendicular to the direction CL in which the pressing member 12 presses the polishing tape 2 against the wafer W. The end surface 48 of the tape hook 40 is an end surface of the tape hook 40 that is the farthest from the reference plane PL. In the embodiment shown in FIG. 3, the end surface 48 of the tape hook 40 is a top surface of the tape hook 40. In this embodiment, a height of the tape hook 40 from the reference plane PL is lower than a height of the tape pressing surfaces 12A, 12B of the pressing member 12 from the reference plane PL.

FIG. 4 is a cross-sectional view showing the polishing tape 2 supported by the pressing member 12 and the tape hooks 40. As shown in FIG. 4, both edges of the polishing tape 2 engage with the tape hooks 40, so that the tape hooks 40 fix the height of both edges of the polishing tape 2 relative to the pressing member 12. Specifically, the center of the polishing tape 2 is lifted by the pressing member 12, while both edges of the polishing tape 2 are in contact with the tape positioning surfaces 47 of the tape hooks 40, so that upward movement (or upward deformation) of both edges of the polishing tape 2 is restricted.

As can be seen from FIG. 4, when viewed from the advancing direction Z of the polishing tape 2, the protrusions 45 of the tape hooks 40 are located between the edges of the polishing tape 2 and the wafer W. As a result, both edges of the polishing tape 2 do not contact the wafer W, while the center of the polishing tape 2 is pressed against the wafer W by the pressing member 12. Therefore, unintentional polishing of the wafer W by the edges of the polishing tape 2 is prevented, while the center of the polishing tape 2 is pressed against the wafer W by the pressing member 12 with a controlled polishing load. A length of each protrusion 45 is not particularly limited, but may be a length that allows the tape hook 40 to engage with the edge of the polishing tape 2 and does not hinder the pressing member 12 from pressing the polishing tape 2 against the wafer W. Specifically, each protrusion 45 has a length that does not contact the pressing member 12 or the pressing-member holder 30. In this specification, the length of the protrusion 45 is defined as a length in a direction perpendicular to the longitudinal direction of the polishing tape 2.

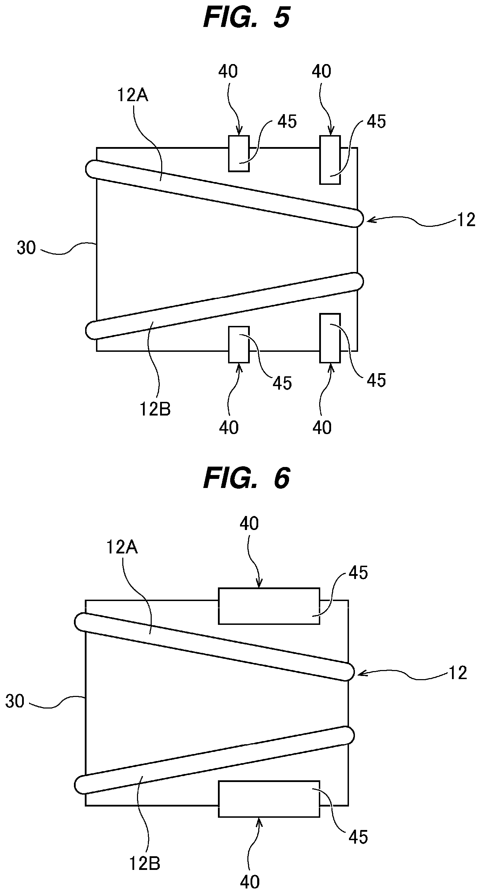

The number and arrangement of the tape hooks 40 are not limited to the embodiment described with reference to FIGS. 1 to 4. For example, as shown in a schematic diagram of FIG. 5, a plurality of sets of tape hooks 40 may be provided at both sides of the pressing member 12. As shown in FIG. 5, the lengths of the protrusions 45 of the tape hooks 40 may be different. For example, the lengths of the protrusions 45 of the tape hooks 40 (the lengths in a direction perpendicular to the longitudinal direction of the polishing tape 2) may increase according to a distance between each tape hook 40 and the pressing member 12. In another example, as shown in FIG. 6, each tape hook 40 may have a width larger than the length of the protrusion 45. Although not shown, the tape hook(s) 40 may be provided only at one side of the pressing member 12 depending on position and/or shape of the pressing member 12. In this case, the movement of only one edge of the polishing tape 2 is restricted by the tape hook(s) 40.

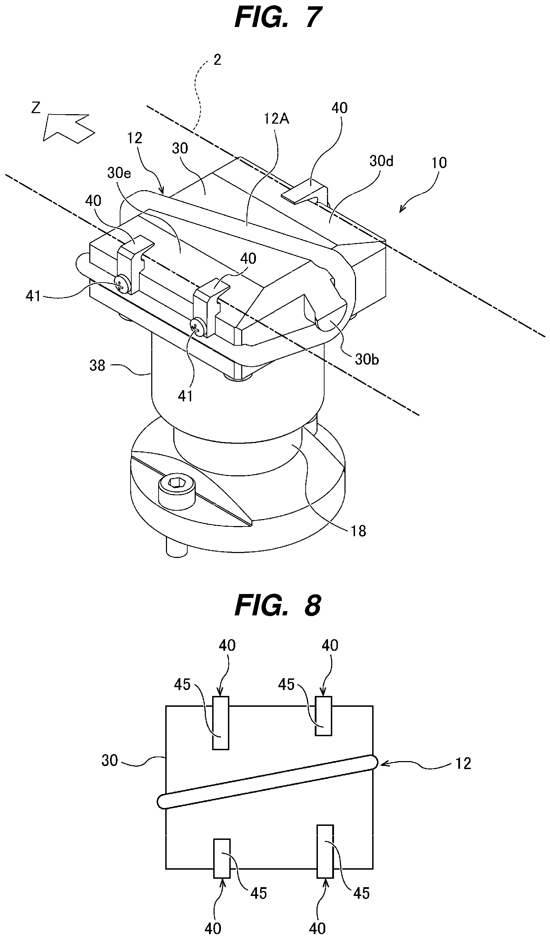

FIG. 7 is a perspective view showing another embodiment of the polishing head 10. Configurations and operations of this embodiment, which will not be specifically described, are the same as those of the embodiments described with reference to FIGS. 1 to 6, and therefore the duplicated descriptions will be omitted.

This embodiment is different from the embodiments described with reference to FIGS. 1 to 6 in that the pressing member 12 has only one tape pressing surface 12A, two tape hooks 40 are provided at one side of the pressing member 12, and one tape hook 40 is provided at the other side. In this embodiment, the tape hooks 40 prevent both edges of the polishing tape 2 from contacting the wafer W, while the center of the polishing tape 2 can be pressed against the wafer W by the pressing member 12. Therefore, unintentional polishing of the wafer W by the edges of the polishing tape 2 is prevented, while the center of the polishing tape 2 is pressed against the wafer W by the pressing member 12 with a controlled polishing load.

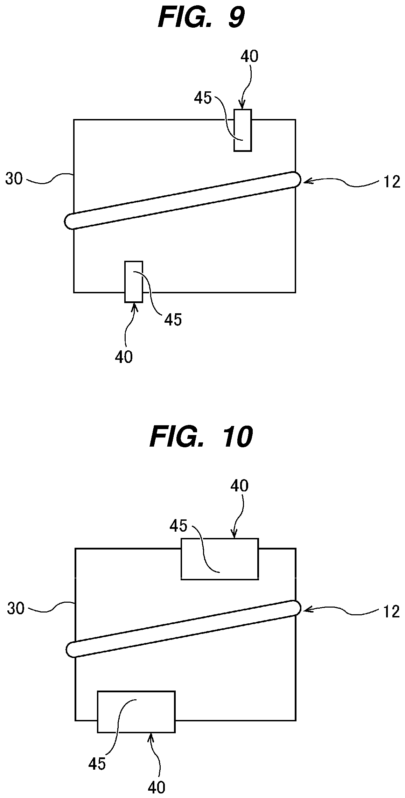

The number and arrangement of the tape hooks 40 are not limited to the embodiment shown in FIG. 7. For example, as shown in the schematic diagram of FIG. 8, a plurality of sets of tape hooks 40 may be provided at both sides of the pressing member 12. As shown in FIG. 8, the lengths of the protrusions 45 of the tape hooks 40 may be different. For example, the lengths of the protrusions 45 of the tape hooks 40 may increase according to a distance between each tape hook 40 and the pressing member 12. In another example, as shown in FIG. 9, one set of tape hooks 40 may be provided at both sides of the pressing member 12. In yet another example, as shown in FIG. 10, each tape hook 40 may have a width larger than the length of the protrusion 45. Although not shown, the tape hook(s) 40 may be provided at only one side of the pressing member 12 depending on position and/or shape of the pressing member 12.

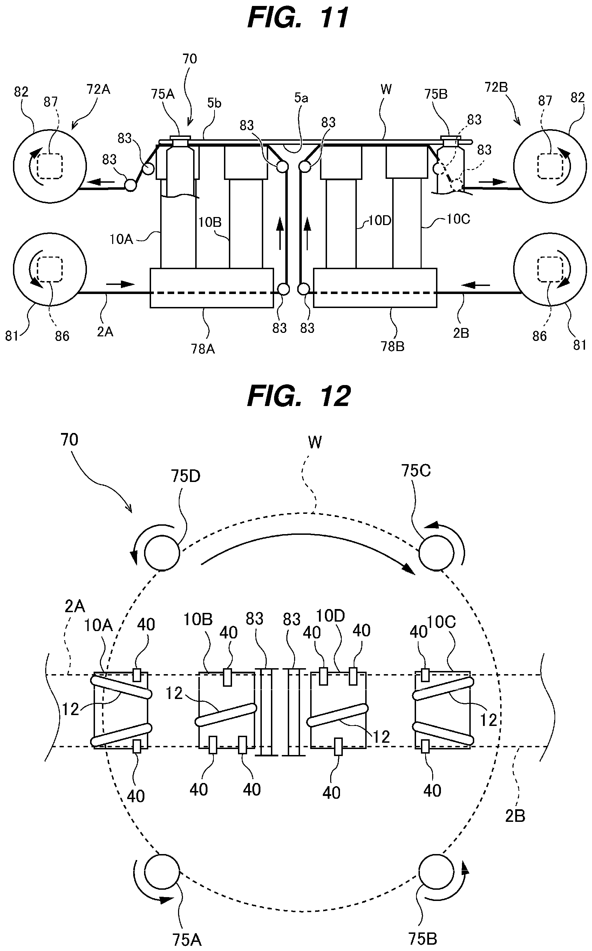

FIG. 11 is a side view showing an embodiment of a polishing apparatus, and FIG. 12 is a top view of the polishing apparatus shown in FIG. 11. The polishing apparatus shown in FIG. 11 and FIG. 12 includes a substrate holder 70 configured to hold and rotate a wafer W, a plurality of polishing heads 10A to 10D configured to bring polishing tapes 2A and 2B into contact with a first surface 5a of the wafer W held by the substrate holder 70 to polish the first surface 5a of the wafer W, a polishing-tape supply mechanism 72A configured to supply a polishing tape 2A to the polishing heads 10A and 10B and collect the polishing tape 2A from the polishing heads 10A and 10B, and a polishing-tape supply mechanism 72B configured to supply a polishing tape 2B to the polishing heads 10C and 10D and collect the polishing tape 2B from the polishing heads 10C and 10D.

The polishing heads 10A and 10C have the same configuration as the polishing head 10 described with reference to FIGS. 1 to 4, and the polishing heads 10B and 10D have the same configuration as the polishing head 10 described with reference to FIGS. 7 to 10. The polishing tapes 2A and 2B have the same configuration.

In this embodiment, the first surface 5a of the wafer W is a back surface of the wafer W on which no devices are formed or no devices are to be formed, i.e., a non-device surface. A second surface 5b of the wafer W opposite to the first surface 5a is a surface on which devices are formed or devices are to be formed, i.e., a device surface. In this embodiment, the wafer W is supported horizontally by the substrate holder 70 with the first surface 5a facing downward.

The substrate holder 70 includes a plurality of rollers 75A, 75B, 75C, and 75D configured to come into contact with the periphery of the wafer W, and a roller-rotating device (not shown) configured to rotate the rollers 75A to 75D at the same speed. In this embodiment, four rollers 75A to 75D are provided, while five or more rollers may be provided.

The polishing heads 10A and 10B are supported by a support member 78A, and the polishing heads 10C and 10D are supported by a support member 78B. The polishing heads 10A to 10D are disposed under the wafer W held by the substrate holder 70. These polishing heads 10A to 10D are arranged in the diameter direction of the wafer W. In this embodiment, four polishing heads 10A to 10D are provided, but the number of polishing heads is not limited to this embodiment. In one embodiment, a single polishing head may be provided.

The polishing-tape supply mechanisms 72A and 72B have the same configuration, and therefore the polishing-tape supply mechanism 72A will be described below. The polishing-tape supply mechanism 72A includes a tape supply reel 81 to which one end of the polishing tape 2A is coupled, a tape take-up reel 82 to which the other end of the polishing tape 2A is coupled, and a plurality of guide rollers 83 configured to guide an advancing direction of the polishing tape 2A. The tape supply reel 81 and the tape take-up reel 82 are coupled to reel motors 86 and 87, respectively.

When the tape take-up reel 82 is rotated in a direction indicated by arrow, the polishing tape 2A is advanced from the tape supply reel 81 to the tape take-up reel 82 via the polishing heads 10A and 10B. The polishing tape 2A is supplied over the polishing heads 10A and 10B such that a polishing surface of the polishing tape 2A faces the first surface 5a of the wafer W. The reel motor 86 applies a predetermined torque to the tape supply reel 81, thereby applying a tension to the polishing tape 2A. The reel motor 87 is controlled to allow the polishing tape 2A to advance at a constant speed. The speed at which the polishing tape 2A advances can be changed by changing a rotational speed of the tape take-up reel 82.

In one embodiment, the polishing apparatus may include a tape-advancing device configured to advance the polishing tape 2A in its longitudinal direction, in addition to the tape supply reel 81, the tape take-up reel 82, and the reel motors 86 and 87. In yet another embodiment, positions of the tape supply reel 81 and the tape take-up reel 82 may be reversed.

The wafer W is polished as follows. While the periphery of the wafer W is held by the plurality of rollers 75A to 75D, the rollers 75A to 75D are rotated to thereby rotate the wafer W. While the polishing tapes 2A and 2B are fed to the polishing heads 10A to 10D by the polishing-tape supply mechanisms 72A and 72B, the pressing members 12 of the polishing heads 10A to 10D press the polishing tapes 2A and 2B against the first surface 5a of the wafer W to polish the first surface 5a of the wafer W.

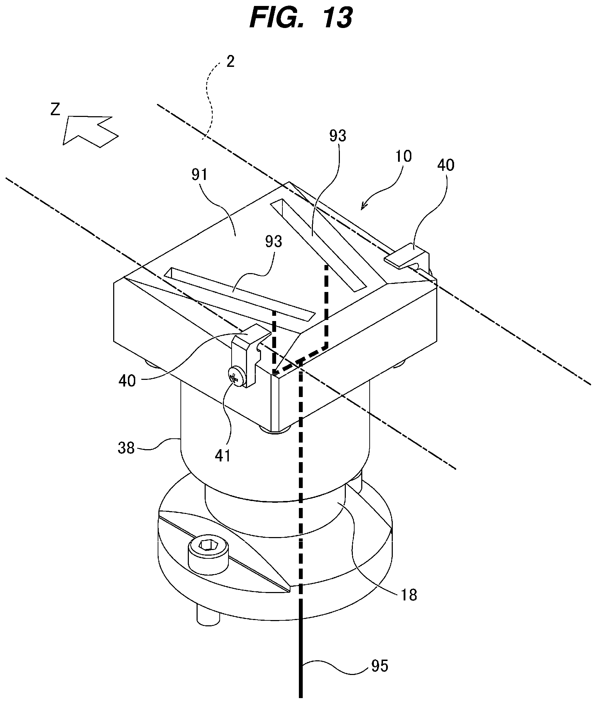

The polishing head 10 described with reference to FIGS. 1 to 10 includes the pressing member 12 that contacts the back side of the polishing tape 2, while in another embodiment, as shown in FIG. 13, the polishing head 10 may include a fluid pressing structure 91 as a pressing mechanism, instead of the pressing member 12. FIG. 13 is a perspective view showing an embodiment of the polishing head 10 including the fluid pressing structure 91. The polishing head 10 has the fluid pressing structure 91 including two fluid supply openings 93. These fluid supply openings 93 are coupled to a fluid supply line 95. In this embodiment, the actuator 15 shown in FIG. 2 may be omitted.

The fluid supply openings 93 are formed in an end surface (or a top surface in FIG. 13) of the fluid pressing structure 91 and face the back side of the polishing tape 2. Each fluid supply opening 93 extends obliquely with respect to the longitudinal direction (advancing direction Z) of the polishing tape 2, as well as the pressing member 12 shown in FIG. 1. The fluid supply opening 93 is a slit-shaped opening. Ends of the fluid supply line 95 are coupled to the fluid supply openings 93, and the other end is coupled to a fluid supply source (not shown). The fluid supply source supplies a fluid, such as a liquid, a gas, or a mixture of a liquid and a gas, to the fluid supply line 95. The fluid reaches the fluid supply openings 93 of the fluid pressing structure 91 through the fluid supply line 95, and is discharged from the fluid supply openings 93 toward the back side of the polishing tape 2. A jet of the fluid can press the polishing tape 2 from its back side against the wafer W.

The tape hooks 40 are disposed at both sides of the two fluid supply openings 93. Configuration, arrangement, and function of the tape hooks 40 are the same as those in the embodiments described with reference to FIGS. 1 to 6, and therefore a duplicated descriptions thereof will be omitted.

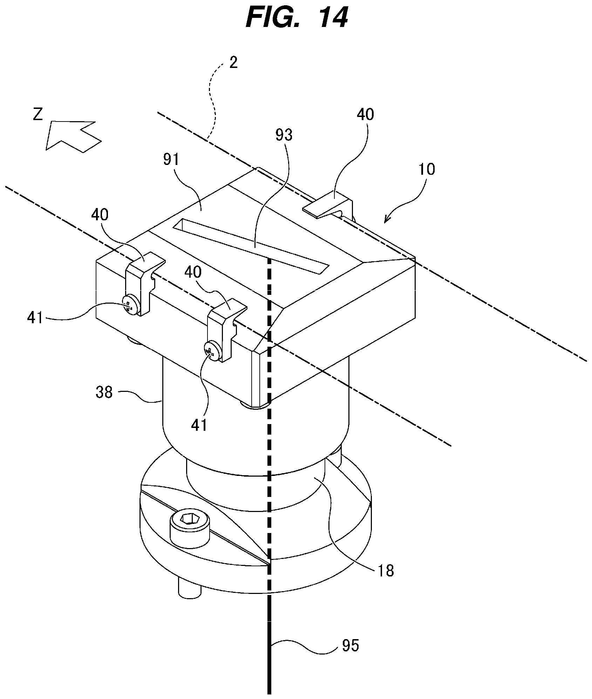

FIG. 14 is a perspective view showing another embodiment of the polishing head 10 having fluid pressing structure 91. Configurations of this embodiment, which will not be particularly described, are the same as those of the embodiment shown in FIG. 13, and repetitive descriptions thereof will be omitted. In the embodiment shown in FIG. 14, the polishing head 10 has fluid pressing structure 91 having only one fluid supply opening 93. As with the pressing member 12 shown in FIG. 7, the fluid supply opening 93 extends obliquely with respect to the longitudinal direction (travel direction Z) of the polishing tape 2. The fluid supply opening 93 is a slit-shaped opening.

The tape hooks 40 are disposed at both sides of the fluid supply opening 93. Configuration, arrangement, and function of the tape hooks 40 are the same as those in the embodiments described with reference to FIGS. 7 to 10, and therefore duplicated descriptions thereof will be omitted.

The tape hook 40 described previously is configured to restrict the movement of the edge of the polishing tape 2 in the direction toward the wafer W by the physical contact with the polishing surface of the polishing tape 2. However, in one embodiment, instead of the tape hook 40, the movement of the edge of the polishing tape 2 in the direction toward the wafer W may be restricted by sucking the back side of the edge of the polishing tape 2 using a vacuum suction port (not shown) formed in the polishing head 10.

The previous description of embodiments is provided to enable a person skilled in the art to make and use the present invention. Moreover, various modifications to these embodiments will be readily apparent to those skilled in the art, and the generic principles and specific examples defined herein may be applied to other embodiments. Therefore, the present invention is not intended to be limited to the embodiments described herein but is to be accorded the widest scope as defined by limitation of the claims.

### Industrial Applicability

The present invention is applicable to a polishing head for pressing a polishing tape against a substrate, such as a wafer. The present invention is further applicable to a polishing apparatus for polishing a substrate using such a polishing head.

### Reference Signs List

- W: wafer
- 2: polishing tape
- 2A, 2B: polishing tape
- 5a: first surface
- 5b: second surface
- 10,10A~ 10D: polishing head
- 12: pressing member
- 12A, 12B: tape-pressing surface
- 15: actuator
- 16: movable shaft
- 18: housing
- 18A: housing body
- 18B: lid
- 20: pressure chamber
- 25: partition membrane
- 30: pressing-member holder
- 30b, 30c: protrusion
- 32: ball spline nut
- 38: skirt
- 40: tape hook
- 45: protrusion
- 47: tape positioning surface
- 48: end surface
- 70: substrate holder
- 72A, 72B: polishing-tape supply mechanism
- 78A, 78B: support member
- 81: tape supply reel
- 82: tape take-up reel
- 83: guide roller
- 86, 87: reel motor
- 91: fluid pressing structure
- 93: fluid supply opening
- 95: fluid supply line

## Claims

1. A polishing head for polishing a substrate, comprising:
a pressing mechanism configured to press a polishing tape against the substrate; and
a tape hook configured to restrict movement of an edge of the polishing tape in a direction toward the substrate, the tape hook having a tape positioning surface that faces a polishing surface of the edge of the polishing tape.

2. The polishing head according to claim 1, wherein the tape hook is disposed adjacent to the pressing mechanism.

3. The polishing head according to claim 1 or 2, wherein the tape hook comprises a plurality of tape hooks arranged at both sides of the pressing mechanism.

4. The polishing head according to claim 3, wherein the plurality of tape hooks have a plurality of tape positioning surfaces that face polishing surfaces of both edges of the polishing tape.

5. The polishing head according to any one of claims 1 to 4, wherein the pressing mechanism comprises a pressing member configured to press the polishing tape against the substrate, the polishing head further comprises a pressing-member holder that holds the pressing member, and a distance from a reference plane in the pressing-member holder to an end surface of the tape hook is shorter than a distance from the reference plane to a tape pressing surface of the pressing member.

6. The polishing head according to claim 5, wherein the tape hook has a protrusion that protrudes toward the pressing member, one side of the protrusion forming the tape positioning surface and an opposite side of the protrusion forming the end surface of the tape hook.

7. The polishing head according to claim 6, wherein the protrusion is located between the substrate and the edge of the polishing tape.

8. The polishing head according to any one of claims 1 to 7, wherein the tape hook and the pressing mechanism are movable together.

9. A polishing apparatus comprising:
a substrate holder configured to hold a substrate; and
a polishing head according to any one of claims 1 to 8 configured to polish the substrate.
